# EUROPEAN PATENT APPLICATION

(11) **EP 4 501 622 A1**
(43) Date of publication of application: **05.02.2025**
(21) Application number: 23779855.8
(22) Date of filing: 20.03.2023
(51) Int. Cl.: B32B 15/04, B32B 3/30, B32B 7/06, B32B 17/06, H05K 1/09

(54) **METAL FOIL WITH CARRIER**

(30) Priority: 31.03.2022 JP 2022059686
(71) Applicant: Mitsui Mining & Smelting Co., Ltd., Shinagawa-ku Tokyo 141-8584 (JP)
(72) Inventor: NAKAMURA, Toshimi, Ageo-shi, Saitama 362-0021 (JP); KITABATAKE, Yukiko, Ageo-shi, Saitama 362-0021 (JP); MATSUURA, Yoshinori, Ageo-shi, Saitama 362-0021 (JP)
(74) Representative: Potter Clarkson
(86) International application number: PCT/JP2023/010949
(87) International publication number: WO 2023/189839

(57) **Abstract**

There is provided a carrier-attached metal foil that can suppress unintended release of a metal layer due to chemical solution infiltration from an end. This carrier-attached metal foil includes a carrier having a first surface and a second surface facing each other, and a side face connected to the first surface and the second surface; a release layer provided on the first surface of the carrier; and a metal layer having a thickness of 0.01 µm or more and 4.0 µm or less provided on the release layer. The metal layer extends from the first surface to the side face of the carrier so that at least a portion of the side face is covered by the metal layer. The carrier has an uneven region having a developed interfacial area ratio Sdr of 3% or more and 39% or less as measured in accordance with ISO 25178 on the side face or the side face and the first surface, and the uneven region encompasses a region of the side face covered by the metal layer.

## Description

### TECHNICAL FIELD

The present invention relates to a carrier-attached metal foil.

### BACKGROUND ART

With the size reduction and functionality enhancement of electronic apparatuses such as portable electronic apparatuses in recent years, further fining (fine pitch) of wiring patterns has been required of printed wiring boards. In order to meet such a requirement, for metal foils for printed wiring board manufacture, those being thinner and having lower surface roughness than before are desired. For example, Patent Literature 1 (JP2005-76091A) discloses a method for manufacturing a carrier-attached superthin copper foil, comprising laminating a release layer and a superthin copper foil in sequence on a smooth surface of a carrier copper foil in which the average surface roughness Rz is reduced to 0.01 µm or more and 2.0 µm or less, and also discloses that high density superfine wiring (fine pattern) is provided by this carrier-attached superthin copper foil to obtain a multilayer printed wiring board.

It has also been recently proposed to use a glass substrate, a polished metal substrate, or the like as an ultrasmooth carrier instead of a conventionally typically used carrier made of a resin and form a metal layer on this ultrasmooth surface by a vapor phase method such as sputtering in order to achieve further reduction of the thickness and surface roughness of a metal layer in a carrier-attached metal foil. For example, Patent Literature 2 (WO2017/150283) discloses a carrier-attached copper foil comprising a carrier (for example, a glass carrier), a release layer, an antireflection layer, and a superthin copper layer in order, and states that the release layer, the antireflection layer, and the superthin copper layer are formed by sputtering. Patent Literature 3 (WO2017/150284) discloses a carrier-attached copper foil comprising a carrier (for example, a glass carrier), intermediate layers (for example, an adhesion metal layer and a release-assisting layer), a release layer, and a superthin copper layer, and states that the intermediate layers, the release layer, and the superthin copper layer are formed by sputtering. In both Patent Literatures 2 and 3, the layers are formed on a carrier such as glass excellent in surface flatness by sputtering, and thus an extremely low arithmetic mean roughness Ra of 1.0 nm or more and 100 nm or less is achieved on the outside surface of the superthin copper layer.

Meanwhile, during the conveyance of a carrier-attached metal foil, and the like, unexpected release of the metal layer may occur by the contact of the laminated portion of the carrier and the metal layer with other members, and several carrier-attached metal foils that can address such a problem are proposed. For example, Patent Literature 4 (JP2016-137727A) discloses a laminate in which part or the whole of the outer peripheries of a metal carrier and a metal foil is covered with a resin, and it is stated that by providing such a configuration, contact with other members can be prevented to reduce the release of the metal foil during handling. Patent Literature 5 (WO2014/054812) discloses a carrier-attached metal foil in which the interface between a carrier made of a resin and a metal foil is strongly adhered via an adhesive layer at at least four corners of the outer peripheral region, and thus unexpected release of a corner portion is prevented, and also discloses that after the completion of conveyance, the carrier-attached metal foil is cut in a portion inside the adhesive layer. Patent Literature 6 (JP2000-331537A) discloses a carrier-attached copper foil in which the surface roughness of the portions of a copper foil carrier in the vicinity of the left and right edges is larger than that of the central portion, and it is stated that thus trouble such as the release of the copper layer from the carrier during the handling of the carrier-attached copper foil and during the fabrication of a copper-clad laminate does not occur.

Further, when mounting an IC chip or the like on a substrate, the carrier-attached metal foil may be cut for the purpose of downsizing to a size that can be processed by the mounting equipment. During this cutting, because the release strength of the release layer exposed at the cutting interface is low, the metal layer may be released from the carrier due to the load during the cutting, and carrier-attached metal foils capable of dealing with this problem have been proposed. For example, Patent Literature 7 (WO2019/163605) discloses that an uneven region having a maximum height Rz of 1.0 µm or more and 30.0 µm or less is linearly provided as a cutting margin on a surface of a flat glass carrier, and it is stated that the undesirable release of a copper layer during the cutting of a glass carrier-attached copper foil and after the cutting can be prevented. Patent Literature 8 (JP2019-102779A) discloses a carrier substrate including a core layer, a first metal layer arranged on the core layer, a release layer arranged on the first metal layer, and a second metal layer arranged on the release layer, wherein at least one of the first metal layer, the release layer, and the second metal layer constitutes a plurality of unit pattern portions having an area smaller than the area of the core layer. According to this configuration, since the unit pattern portions are designed to prevent separation, it is possible to prevent the release layer from being separated during the process of sawing into quad or strip units.

### CITATION LIST

### PATENT LITERATURE

Patent Literature 1: JP2005-76091A
Patent Literature 2: WO2017/150283
Patent Literature 3: WO2017/150284
Patent Literature 4: JP2016-137727A
Patent Literature 5: WO2014/054812
Patent Literature 6: JP2000-331537A
Patent Literature 7: WO2019/163605
Patent Literature 8: JP2019-102779A

### SUMMARY OF INVENTION

In the step of forming a redistribution layer including a wiring layer and a resin layer using a carrier-attached metal foil, various kinds of chemical solutions such as a liquid resist developer, a stripping solution, a copper sulfate plating solution, and a metal layer etching solution are used. The use of such chemical solutions causes chemical solution damage to build up at the end of the carrier-attached metal foil. Further, the chemical solutions may infiltrate the release layer or the like from the end of the carrier-attached metal foil, and the metal layer may be unintendedly released from the carrier. As a result, a problem is that an intended circuit pattern cannot be formed, and it is not possible to proceed to the subsequent steps.

The inventors have now found that, in a carrier-attached metal foil, by extending a metal layer from one surface to a side face of the carrier, and providing on the side face of the carrier an uneven region having a developed interfacial area ratio Sdr controlled in a predetermined range so as to encompass the region covered by the metal layer, it is possible to suppress unintended release of the metal layer due to chemical solution infiltration from the end.

Therefore, an object of the present invention is to provide a carrier-attached metal foil that can suppress unintended release of the metal layer due to chemical solution infiltration from the end.

The present invention provides the following aspects:
[Aspect 1]
   A carrier-attached metal foil comprising:
   a carrier having a first surface and a second surface facing each other, and a side face connected to the first surface and the second surface;
   a release layer provided on the first surface of the carrier; and
   a metal layer having a thickness of 0.01 µm or more and 4.0 µm or less provided on the release layer,
   wherein the metal layer extends from the first surface to the side face of the carrier so that at least a portion of the side face is covered by the metal layer,
   wherein the carrier has an uneven region having a developed interfacial area ratio Sdr of 3% or more and 39% or less as measured in accordance with ISO 25178 on the side face or the side face and the first surface, and
   wherein the uneven region encompasses a region of the side face covered by the metal layer.
[Aspect 2]
   The carrier-attached metal foil according to aspect 1, wherein the uneven region is provided over an entire circumference of the side face.
[Aspect 3]
   The carrier-attached metal foil according to aspect 1 or 2,
   wherein the carrier has a flat region having a developed interfacial area ratio Sdr of less than 5% as measured in accordance with ISO 25178 and the uneven region surrounding the flat region on the first surface, and
   wherein the uneven region is provided continuously from the side face to the first surface of the carrier.
[Aspect 4]
   The carrier-attached metal foil according to aspect 3, wherein, on the first surface of the carrier, a ratio of an area of the uneven region to a total area of the flat region and the uneven region is 0.01 or more and 0.5 or less.
[Aspect 5]
   The carrier-attached metal foil according to aspect 3 or 4, wherein the uneven region is provided on the first surface in a pattern defining the flat region into two or more sections.
[Aspect 6]
   The carrier-attached metal foil according to any one of aspects 1 to 5,
   wherein the carrier-attached metal foil has, on the uneven region, a stepped portion that is lower in height than a flat surface of the metal layer in the flat region, and
   wherein a height difference between the stepped portion and the flat surface is more than 0.05 µm and 100 µm or less.
[Aspect 7]
   The carrier-attached metal foil according to any one of aspects 1 to 6, wherein the carrier has a micro-Vickers hardness of 500 HV or more and 3000 HV or less.
[Aspect 8]
   The carrier-attached metal foil according to any one of aspects 1 to 7, wherein the metal layer is composed of at least one metal selected from the group consisting of Cu, Au, and Pt.
[Aspect 9]
   The carrier-attached metal foil according to any one of aspects 1 to 8, further comprising an intermediate layer between the carrier and the release layer, the intermediate layer comprising at least one metal selected from the group consisting of Cu, Ti, Al, Nb, Zr, Cr, W, Ta, Co, Ag, Ni, In, Sn, Zn, Ga, and Mo.
[Aspect 10]
   The carrier-attached metal foil according to any one of aspects 1 to 9, further comprising a functional layer between the release layer and the metal layer, the functional layer being composed of at least one metal selected from the group consisting of Ti, Al, Nb, Zr, Cr, W, Ta, Co, Ag, Ni, and Mo.
[Aspect 11]
   The carrier-attached metal foil according to any one of aspects 1 to 10, wherein the carrier is a glass substrate comprising SiOz or a silicon substrate.
[Aspect 12]
   The carrier-attached metal foil according to aspect 11, wherein the carrier is a glass substrate composed of at least one glass selected from the group consisting of quartz glass, borosilicate glass, alkali-free glass, soda lime glass, and aluminosilicate glass.
[Aspect 13]
   The carrier-attached metal foil according to any one of aspects 1 to 12, wherein the carrier in the uneven region has a release strength of 20 gf/cm or more and 3000 gf/cm or less.
[Aspect 14]
   The carrier-attached metal foil according to any one of aspects 1 to 13,
   wherein the carrier-attached metal foil has a redistribution layer on the metal layer, and
   wherein when the carrier-attached metal foil is viewed in plan view, at least a portion of the redistribution layer reaches an end of the carrier.
[Aspect 15]
   The carrier-attached metal foil according to aspect 14, wherein at least a portion of the end of the redistribution layer is located on the uneven region.
[Aspect 16]
   The carrier-attached metal foil according to any one of aspects 1 to 15, wherein a line width of the pattern of the uneven region R provided on the first surface is 0.1 mm or more and 50 mm or less.
[Aspect 17]
   The carrier-attached metal foil according to any one of aspects 1 to 16, further comprising:
   a second release layer provided on the second surface of the carrier; and
   a second metal layer having a thickness of 0.01 µm or more and 4.0 µm or less provided on the second release layer,
   wherein the second metal layer extends from the second surface to the side face of the carrier so that at least a portion of the side face is covered by the second metal layer,
   wherein the carrier further has the uneven region on the second surface, and
   wherein the uneven region encompasses a region of the side face covered by the second metal layer.

### BRIEF DESCRIPTION OF DRAWINGS

Figure 1 is a schematic cross-sectional view showing an example of the carrier-attached metal foil of the present invention.
Figure 2 is a schematic cross-sectional view of the carrier, showing a first surface, a second surface, and a side face.
Figure 3A is a top view showing a wafer-shaped carrier from the first surface side, in which an uneven region surrounds a flat region.
Figure 3B is a top view showing a panel-shaped carrier from the first surface side, in which an uneven region surrounds a flat region.
Figure 4 is a step flowchart showing an example of a conventional wiring formation process using a carrier-attached metal foil.
Figure 5 is a step flowchart showing an example of another wiring formation process using a carrier-attached metal foil.
Figure 6 is a step flowchart showing an example of a wiring formation process according to an aspect of the carrier-attached metal foil of the present invention.
Figure 7A is a step flowchart for illustrating changes in the surface profile of the carrier resulting from the progress of a blasting treatment, in which the first half of the steps are shown.
Figure 7B is a step flowchart for illustrating changes in the surface profile of the carrier resulting from the progress of a blasting treatment, in which the latter steps following Figure 7A are shown.
Figure 8A is a schematic cross-sectional view for explaining a method for measuring a breaking load.
Figure 8B is a schematic top view showing the positional relationship between the carrier and the supporting members S shown in Figure 8A.

### DESCRIPTION OF EMBODIMENTS

### Definitions

The "developed interfacial area ratio Sdr" or "Sdr" herein is a parameter that represents how much the developed area (surface area) of a defined region increases with respect to the area of the defined region, measured in accordance with ISO 25178. The developed interfacial area ratio Sdr is herein represented as an increase (%) in surface area. A smaller value of this indicates a nearly flat surface shape, and the Sdr of a completely flat surface is 0%. On the other hand, a larger value of this indicates a more uneven surface shape. For example, when the Sdr of a surface is 30%, it is indicated that the surface area of this surface increases from that of a completely flat surface by 30%. Sdr can be calculated by measuring the surface profile of a predetermined measurement area (for example, a two-dimensional region of 258.346 µm × 258.348 µm) on a surface of interest by a commercially available laser microscope (for example, using a 50× magnification objective lens). The numerical value of the Sdr herein is a value measured by setting the cutoff wavelength by an S filter to 0.8 µm, without using cutoff by an L filter.

### Carrier-Attached Metal Foil

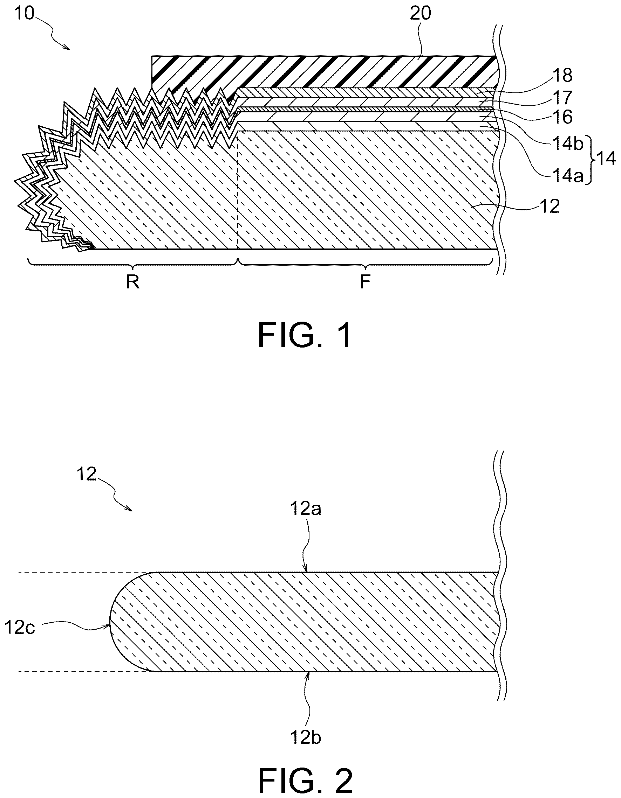

One example of the carrier-attached metal foil of the present invention is schematically shown in Figure 1. As shown in Figure 1, the carrier-attached metal foil 10 of the present invention comprises a carrier 12, a release layer 16, and a metal layer 18 in this order. Optionally, the carrier-attached metal foil 10 may further have an intermediate layer 14 between the carrier 12 and the release layer 16, and may further have a functional layer 17 between the release layer 16 and the metal layer 18. Further, the carrier-attached metal foil 10 may further have a redistribution layer 20 on the metal layer 18. As shown in Figure 2, the carrier 12 has a first surface 12a and a second surface 12b facing each other, and a side face 12c connected to the first surface 12a and the second surface 12b. The release layer 16 is a layer provided on the carrier 12. The metal layer 18 is provided on the release layer 16 and having a thickness of 0.01 µm or more and 4.0 µm or less. This metal layer 18 extends from the first surface 12a to the side face 12c of the carrier, and so at least a portion of the side face 12c of the carrier 12 is covered by the metal layer 18. The carrier 12 has an uneven region R having a developed interfacial area ratio Sdr of 3% or more and 39% or less on the side face 12c or on the side face 12c and the first surface 12a. This uneven region R encompasses the region of the side face 12c covered by the metal layer 18. Thus, in the carrier-attached metal foil 10, by extending the metal layer 18 from the first surface 12a to the side face 12c of the carrier, and providing on the side face 12c of the carrier the uneven region R having a developed interfacial area ratio Sdr controlled in a predetermined range so as to encompass the region covered by the metal layer 18, it is possible to suppress unintended release of the metal layer 18 due to chemical solution infiltration from the end.

As described above, in the step of forming a redistribution layer using a carrier-attached metal foil, various chemical solutions such as a dry film resist developer, a stripping solution, a copper sulfate plating solution, and a metal layer etching solution are used. The use of those chemical solutions causes chemical solution damage to build up at the end of the carrier-attached metal foil. Further, the chemical solutions may infiltrate the release layer or the like from the end of the carrier-attached metal foil, and the metal layer may be unintendedly released from the carrier. As a result, a problem is that an intended circuit pattern cannot be formed, and it is not possible to proceed to the subsequent steps.

This problem is advantageously solved by the carrier-attached metal foil 10 of the present invention. First, because at least a portion of the side face 12c of the carrier is covered by the metal layer 18, chemical solution infiltration can be suppressed without exposing the end of the release layer 16. On the other hand, even with such a configuration, it is expected that the end of the metal layer 18 and the like may be dissolved and a chemical solution may infiltrate up to the release layer 16. In this respect, by providing the uneven region R so as to encompass the region of the side face 12c covered by the metal layer 18, the various layers extending to the side face 12c, such as the metal layer 18, also have a shape rich in unevenness. Therefore, even if a chemical solution infiltrates from the end of the carrier-attached metal foil 10, the uneven shapes suppress further infiltration of the chemical solution, and it is possible to prevent the chemical solution from reaching the release layer 16 present on the first surface 12a of the carrier. As a result, unintended release of the metal layer 18 can be extremely effectively suppressed, and it is also possible to sufficiently withstand a multilayer wiring formation process.

It is preferred that the uneven region R is provided over the entire circumference of the side face 12c of the carrier. By doing so, it is possible to prevent a chemical solution from infiltrating the release layer 16 all around the carrier-attached metal foil 10, and it is possible to suppress unintended release of the metal layer 18 even more effectively. When the carrier 12 is viewed in cross section, the side face 12c of the carrier may have a curved shape (see Figure 2), or may have a planar shape in which the first surface 12a and the second surface 12b are perpendicularly connected. However, from the viewpoint of preventing the carrier 12 from cracking, it is preferred that the carrier 12 has a curved shape.

The uneven region R of the carrier 12 has a developed interfacial area ratio Sdr of 3% or more and 39% or less, preferably 3.5% or more and 35% or less, more preferably 4.0% or more and 30% or less, further preferably 4.5% or more and 25% or less, and particularly preferably 5% or more and 15% or less. Within this range, the ease of being released from the release layer 16 in the uneven region R is reduced (adhesion is improved), and unintended release of the metal layer can be effectively suppressed. Further, a decrease in the strength of the carrier 12 can be effectively suppressed. Moreover, when the uneven region R is also provided on the first surface 12a, when the carrier-attached metal foil 10 is cut according to the pattern of the uneven region R as described later, good release strength on the cutting surface(s) can be ensured, and undesirable release of the metal layer 18 accompanying the cutting can be more effectively suppressed. In addition, pointed portions and cracked portions are less likely to occur on the carrier 12 surface, and therefore it is possible to reduce the number of the particulate broken pieces of the carrier that occur when the carrier-attached metal foil 10 is cut. The release strength of the carrier 12 in the uneven region R is preferably 20 gf/cm or more and 3000 gf/cm or less, more preferably 25 gf/cm or more and 2000 gf/cm or less, further preferably 30 gf/cm or more and 1000 gf/cm or less, particularly preferably 35 gf/cm or more and 500 gf/cm or less, and most preferably 50 gf/cm or more and 300 gf/cm or less. Within this range, undesirable release of the metal layer 18 can be effectively suppressed even during cutting of the carrier-attached metal foil 10, and the uneven region R can be formed with good productivity. This release strength is a value measured in accordance with JIS Z 0237-2009, as mentioned in Examples described later.

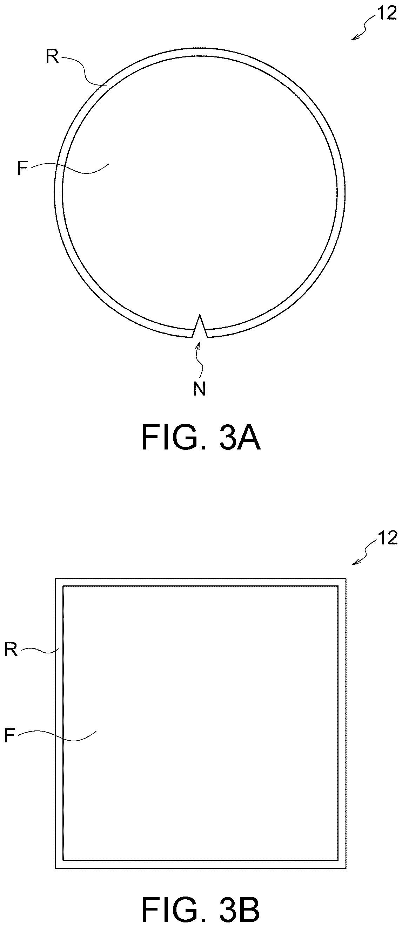

As shown in Figures 3A and 3B, the carrier 12 preferably has a flat region F and an uneven region R surrounding the flat region F on the first surface 12a. The flat region F of the carrier 12 has a developed interfacial area ratio Sdr of less than 5%, preferably 0.01% or more and 4.0% or less, more preferably 0.03% or more and 3.0% or less, further preferably 0.05% or more and 1.0% or less, particularly preferably 0.07% or more and 0.50% or less, and most preferably 0.08% or more and 0.50% or less. Since the carrier 12 has a flat region F with a small Sdr, the surface of the flat region F of the metal layer 18 laminated on the first surface 12a of the carrier via the release layer 16 also has a flat shape, and so fine patterns can be preferably formed due to this flat surface of the metal layer 18. The shape of the carrier 12 when seen in plan view may be a circular shape (wafer shape) shown in Figure 3A, or a rectangular shape (rectangular or square panel shape) shown in Figure 3B. When the carrier 12 is a single-crystal silicon carrier, it typically has a notch N shown in Figure 3A or an orientation flat on an outer periphery portion to indicate a reference point for crystal orientation. Generally, when the diameter of single crystal silicon is 200 mm or less, an orientation flat is formed, and when the diameter is 200 mm or more, a notch N is formed.

When the first surface 12a of the carrier has the uneven region R, it is preferred that the uneven region R is provided continuously from the side face 12c to the first surface 12a of the carrier, as shown in Figure 1. By doing so, even after unnecessary portions of the metal layer 18 (and the functional layer 17 if present) are etched away, infiltration of a chemical solution into the release layer 16 can be effectively suppressed. This effect will be explained below by comparing with a conventional carrier-attached metal foil.

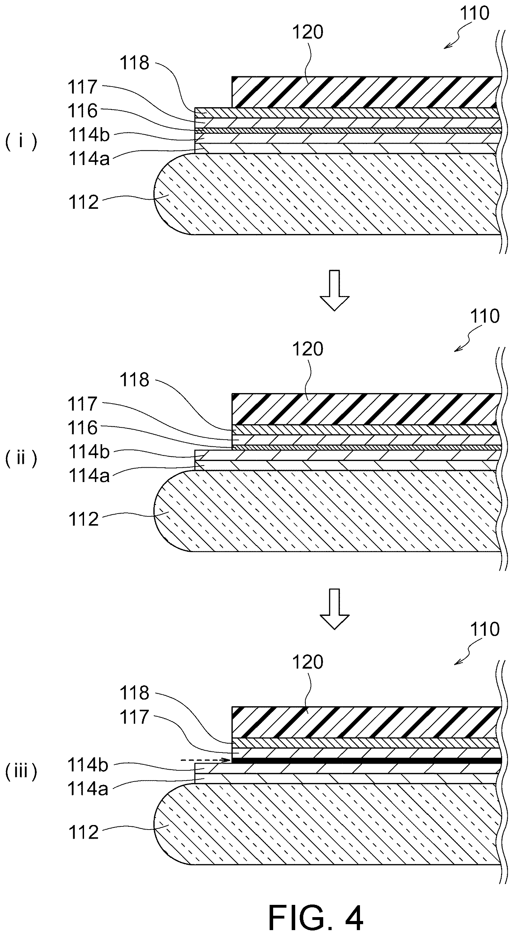

First, Figure 4 shows an example of a wiring formation process using a conventional carrier-attached metal foil 110. This carrier-attached metal foil 110 includes a first intermediate layer 114a, a second intermediate layer 114b, a release layer 116, a functional layer 117, a metal layer 118, and a redistribution layer 120, in this order, on a carrier 112, and an end of the release layer 116 is exposed (Figure 4(i)). Formation of a photoresist layer, formation of an electrodeposited copper plating layer, stripping of the photoresist layer, and optionally copper flash etching are performed in accordance with known methods for forming wiring on this carrier-attached metal foil 110. For example, these processes are carried out as follows. First, the photoresist layer is formed in a predetermined pattern on the surface of the metal layer 118. Preferably, the photoresist is a photosensitive film, such as a photosensitive dry film. The photoresist layer may be provided with a predetermined wiring pattern by exposure and development. If necessary, an electrodeposited copper plating layer is formed on the exposed surface of metal layer 118 (that is, the portion not masked by the photoresist layer). Electrodeposited copper plating may be performed by a known method and is not particularly limited. Then, the photoresist layer is stripped. After unnecessary portions of the metal layer 118 and the functional layer 117 are removed in this way (Figure 4(ii)), when the carrier-attached metal foil 110 is immersed in a chemical solution (Figure 4(iii)), unintended release between the carrier 112 and the metal layer 118 may occur due to infiltration of the chemical solution from the exposed end of the release layer 116.

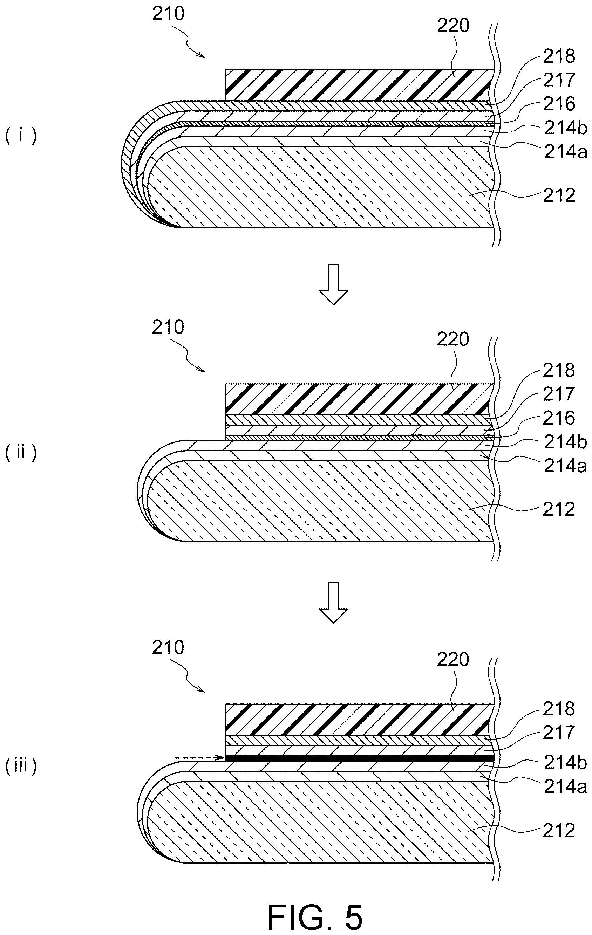

Figure 5 shows another example of a wiring formation process using a carrier-attached metal foil 210. This carrier-attached metal foil 210 includes a first intermediate layer 214a, a second intermediate layer 214b, a release layer 216, a functional layer 217, a metal layer 218, and a redistribution layer 220, in this order, on the carrier 212, and the side face of the carrier 212 is covered by the metal layer 218 (Figure 5(i)). This carrier-attached metal foil 210 is etched in the same manner as in the wiring formation process described above, and after unnecessary portions of the metal layer 218 and the functional layer 217 are removed (Figure 5(ii)), when the carrier-attached metal foil 210 is immersed in a chemical solution (Figure 5(iii)), unintended release between the carrier 212 and the metal layer 218 may occur due to infiltration of the chemical solution from the exposed end of the release layer 216.

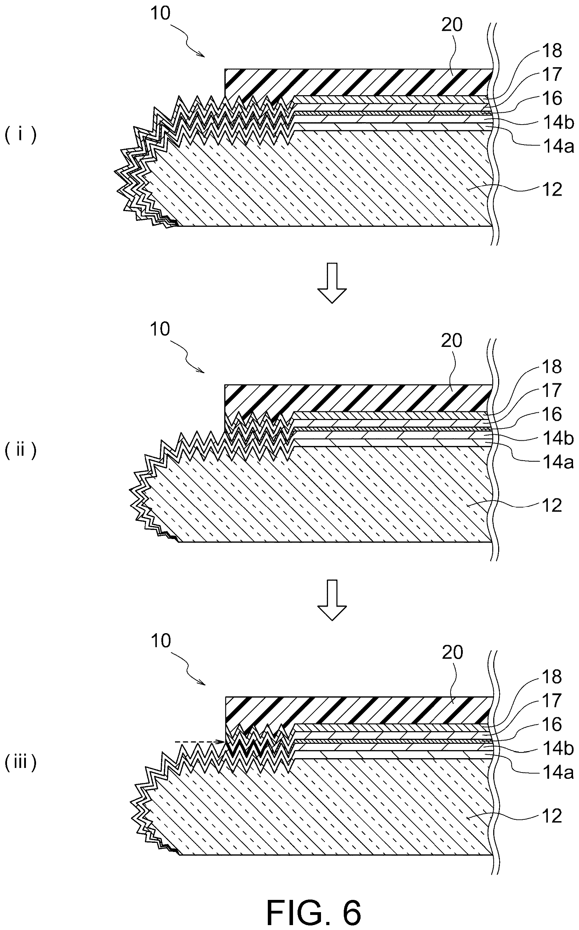

On the other hand, Figure 6 shows an example of a wiring formation process according to an aspect of the carrier-attached metal foil 10 of the present invention. As shown in Figure 6(i), this carrier-attached metal foil 10 includes a first intermediate layer 14a, a second intermediate layer 14b, a release layer 16, a functional layer 17, a metal layer 18, and a redistribution layer 20, in this order, on the carrier 12. The side face 12c of the carrier is covered by the metal layer 18, and the uneven region R is continuously provided from the side face 12c to the first surface 12a of the carrier. This carrier-attached metal foil 10 is etched in the same manner as in the wiring formation process described above to remove unnecessary portions of the metal layer 18 and functional layer 17 (Figure 6(ii)), and when the carrier-attached metal foil 10 is immersed in a chemical solution (Figure 6(iii)), the exposed end of the release layer 16 comes into contact with the chemical solution. However, due to the presence of the uneven region R on the first surface 12a of the carrier, various layers such as the release layer 16 on the first surface 12a also have a shape rich in unevenness. Therefore, even if the chemical solution infiltrates from the exposed end of the release layer 16, the uneven shapes suppress further infiltration of the chemical solution, and lengthens the time taken by the chemical solution to reach (or even prevents the chemical solution from reaching) the interior of the release layer 16 (for example, inside the flat region F).

The uneven region R may be provided over the entire region in the height direction (direction perpendicular to the first surface 12a and second surface 12b) of the side face 12c of the carrier. This makes the strength of the carrier 12 uniform, and also contributes to preventing cracking. That is, when the carrier 12 is viewed in cross section and the height of the first surface 12a is 0% and the height of the second surface 12b is 100%, it is preferred that the uneven region R is provided continuously on the side face 12c up to a height of more than 0% and 100% or less. The upper limit value of this height is not particularly limited, but from the viewpoint of formability of the uneven region R, it is typically 95% or less, more typically 90% or less, and further typically 85% or less. On the other hand, from the viewpoint of providing the uneven region R continuously from the side face 12c to the first surface 12a of the carrier, the lower limit value of the height is preferably 0%.

From the viewpoint of sufficiently ensuring that the metal layer 18 has a region (that is, flat region F) capable of providing the flatness necessary for forming a fine pattern, it is preferred that, on the first surface 12a of the carrier, a ratio of the area of the uneven region R to the total area of the flat region F and the uneven region R is 0.01 or more and 0.5 or less. The ratio of the area of the uneven region R is more preferably 0.02 or more and 0.45 or less, further preferably 0.05 or more and 0.40 or less, and particularly preferably 0.1 or more and 0.35 or less.

The uneven region R may be provided on the first surface 12a in a pattern defining the flat region F into two or more sections. In the case of such a configuration, by cutting the carrier-attached metal foil 10 according to the pattern of the uneven region R, a plurality of carrier-attached metal foils 10 each having a flat region F and downsized to a size that can be processed by the circuit mounting equipment can be obtained. In the downsized carrier-attached metal foil 10, a cutting surface is present in the uneven region R, and therefore the release strength of the release layer 16 on the cutting surface is high, and therefore undesirable release of the metal layer 18 from the cutting surface can be extremely effectively prevented not only during the cutting but also after the cutting (for example, during the conveyance of the carrier-attached metal foil in a mounting step and during handling). The pattern of the uneven region R is preferably provided in a lattice form, a fence form, or a cross form in terms of easily defining the plurality of flat regions F in an equal shape and size suitable for a circuit-mounted substrate. Especially, the pattern of the uneven region R is particularly preferably provided in a lattice form or a fence form. By doing so, the whole or most of the periphery of each flat region F can be surrounded by the uneven region R, which makes it more difficult for starting points of unintended release to occur at the end of each carrier-attached metal foil 10 divided after cutting.

The line width of the pattern of the uneven region R provided on the first surface 12a is preferably 0.1 mm or more and 50 mm or less, more preferably 0.2 mm or more and 45 mm or less, further preferably 0.3 mm or more and 40 mm or less, and particularly preferably 0.3 mm or more and 35 mm or less. By setting within such a range, a cutting means such as a cutter can be easily positioned in the uneven region R, the cutting itself is also easier to perform, and it is possible to desirably realize the various advantages of the uneven region R while securing a large number of flat regions F.

Although the method for forming the uneven region R is not particularly limited, it is preferred that the uneven region R is formed by, for example, processing a predetermined region of a flat surface of the carrier 12 by a physical method such as blasting treatment. Therefore, the carrier-attached metal foil 10 typically has, on the uneven region R, a stepped portion that is lower in height than the flat surface of the metal layer 18 in the flat region F. The difference in height between the stepped portion and the flat surface is preferably more than 0.05 µm and 100 µm or less, more preferably 0.1 µm or more and 80 µm or less, further preferably 0.5 µm or more and 50 µm or less, and particularly preferably 1 µm or more and 30 µm or less. Within this range, it is possible to prevent the strength of the carrier 12 from decreasing as described later while more effectively suppressing infiltration of a chemical solution inside the release layer 16 (for example, into the flat region F). The height difference of the stepped portion can be calculated by measuring and analyzing the surface profile on the first surface 12a using a commercially available laser microscope. Preferred measurement conditions and analysis conditions for the height difference of the stepped portion using a laser microscope will be discussed in the Examples later.

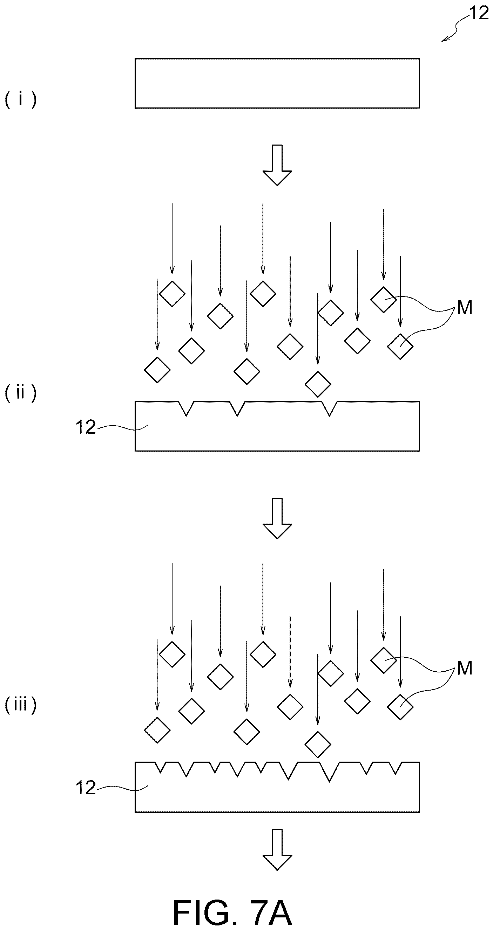

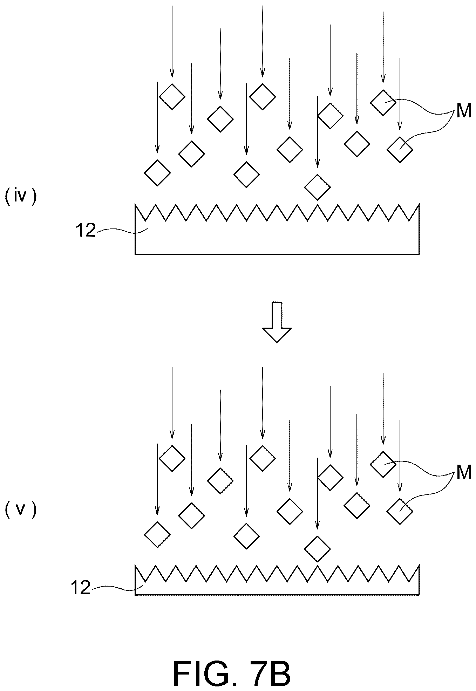

Changes in the surface profile of the carrier 12 resulting from the progress of the blasting treatment will now be described with reference to Figure 7A and 7B. First, when a media M is projected onto the surface of a prepared carrier 12 by blasting treatment, chipping occurs on the surface of the carrier 12 due to the collisions by the media M (Figures 7A(i) and (ii)). As the projection of the media M continues, this chipping gradually progresses, causing the surface profile of the carrier 12 to change (Figure 7A (iii)). The chipping subsequently continues across the entire processing region of the carrier 12, whereby the surface profile is completely changed (Figure 7B(iv)). If the projection of the media M is further continued from this state, the carrier 12 is chipped away while maintaining its new surface profile, causing the thickness of the carrier 12 to become thinner, resulting in a decrease in strength. In this regard, it is possible to prevent the strength from decreasing due to the carrier 12 becoming too thin while exhibiting the desired function as the uneven region R by controlling the height difference of the stepped portion to be within the above range.

The material of the carrier 12 is not particularly limited as long as it has an Sdr within the above-described predetermined range (or the Sdr can be controlled by processing), but the carrier 12 is preferably composed of glass, silicon, or metal, and more preferably is a glass substrate containing SiOz or a silicon substrate. The silicon substrate may be any substrate as long as it contains Si as an element, such as a SiOz substrate, a SiN substrate, a Si single crystal substrate, or a Si polycrystalline substrate, but is preferably a Si single crystal substrate or a Si polycrystalline substrate. Preferred examples of a metal constituting the carrier 12 include copper, titanium, nickel, stainless steel, and aluminum. The form of the carrier 12 may be any of a sheet, a film, and a plate. The carrier 12 may be a laminate of these sheets, films, plates, and the like. For example, the carrier 12 is preferably one that can function as a support having rigidity, such as a SiOz substrate, a Si single crystal substrate, or a glass plate. More preferably, from the viewpoint of preventing the warpage of the carrier-attached metal foil 10 in a process involving heating, the carrier 12 is a Si single crystal substrate or a glass plate having a coefficient of thermal expansion (CTE) of less than 25 ppm/K (typically 1.0 ppm/K or more and 23 ppm/K or less). From the viewpoint of handleabililty and ensuring flatness during chip mounting, the micro-Vickers hardness of the carrier 12 is preferably 500 HV or more and 3000 HV or less, more preferably 600 HV or more and 2000 HV or less. When glass is used as the carrier, advantages are that it is lightweight, has a low coefficient of thermal expansion, has high insulating properties, has high rigidity, and has a flat surface and therefore the surface of the metal layer 18 can be extremely smoothed. In addition, when the carrier is glass, advantages are that it is excellent in visibility when image inspection is performed after a wiring layer is formed, that it has surface flatness (coplanarity) advantageous during electronic device mounting, that it has chemical resistance in desmear and various plating steps in a printed wiring board manufacturing process, and that a chemical separation method can be adopted when the carrier 12 is released from the carrier-attached metal foil 10. The carrier 12 is preferably a glass substrate comprising SiO₂, more preferably glass comprising 50% by weight or more of SiO₂, further preferably 60% by weight or more of SiOz. Preferred examples of the glass constituting the carrier 12 include quartz glass, borosilicate glass, alkali-free glass, soda lime glass, aluminosilicate glass, and combinations thereof, more preferably borosilicate glass, alkali-free glass, soda lime glass, and combinations thereof, particularly preferably alkali-free glass, soda lime glass, and combinations thereof, and most preferably alkali-free glass. The carrier 12 is preferably composed of borosilicate glass, alkali-free glass, or soda lime glass because the chipping of the carrier 12 can be reduced when the carrier-attached metal foil 10 is cut. The alkali-free glass is glass containing substantially no alkali metals that comprises silicon dioxide, aluminum oxide, boron oxide, and alkaline earth metal oxides such as calcium oxide and barium oxide as main components and further contains boric acid. An advantage of this alkali-free glass is that it has a low coefficient of thermal expansion in the range of 3 ppm/K or more and 5 ppm/K or less and is stable in a wide temperature zone of 0°C to 350°C, and therefore the warpage of the glass in a process involving heating can be minimized. When a substrate containing silicon is used as the carrier 12, because the carrier 12 is lightweight like glass, has a low coefficient of thermal expansion, has high insulation properties, is rigid, and has a flat surface, there are advantages such as the surface of the metal layer 18 can be made extremely smooth. Further, when the carrier 12 is a substrate containing silicon, there are advantages such as the carrier 12 has a surface flatness (coplanarity) that is advantageous for forming fine circuits, has chemical resistance during the desmearing in the wiring production step and in the various plating steps, and a chemical separation method can be employed when releasing the carrier 12 from the carrier-attached metal foil 10. The thickness of the carrier 12 is preferably 100 µm or more and 2000 µm or less, more preferably 300 µm or more and 1800 µm or less, and further preferably 400 µm or more and 1100 µm or less. When the carrier 12 has a thickness within such a range, the thinning of a printed wiring board, and the reduction of warpage that occurs during electronic component mounting can be achieved while suitable strength that does not hinder handling is ensured.

The optionally provided intermediate layer 14 is a layer interposed between the carrier 12 and the release layer 16 and contributing to ensuring the adhesion between the carrier 12 and the release layer 16. Examples of the metal constituting the intermediate layer 14 include Cu, Ti, Al, Nb, Zr, Cr, W, Ta, Co, Ag, Ni, In, Sn, Zn, Ga, Mo, and combinations thereof (hereinafter referred to as a metal M), preferably Cu, Ti, Al, Nb, Zr, Cr, W, Ta, Co, Ag, Ni, Mo, and combinations thereof, more preferably Cu, Ti, Zr, Al, Cr, W, Ni, Mo, and combinations thereof, further preferably Cu, Ti, Al, Cr, Ni, Mo, and combinations thereof, and particularly preferably Cu, Ti, Al, Ni, and combinations thereof. The intermediate layer 14 may be a pure metal or an alloy. The metal constituting the intermediate layer 14 may comprise unavoidable impurities due to the raw material component, the film formation step, and the like. In the case of exposure to the air after the film formation of the intermediate layer 14, the presence of oxygen mixed due to the exposure is allowed, which is not particularly limited. The upper limit of the content of the metal is not particularly limited and may be 100 atomic %. The intermediate layer 14 is preferably a layer formed by a physical vapor deposition (PVD) method, more preferably a layer formed by sputtering. The intermediate layer 14 is particularly preferably a layer formed by a magnetron sputtering method using a metal target, from the viewpoint of the uniformity of film thickness distribution. The thickness of the intermediate layer 14 is preferably 10 nm or more and 1000 nm or less, more preferably 30 nm or more and 800 nm or less, further preferably 60 nm or more and 600 nm or less, and particularly preferably 100 nm or more and 400 nm or less. By setting such a thickness, an intermediate layer having a roughness equivalent to that of the carrier can be provided. This thickness is a value measured by analyzing a layer cross section by a transmission electron microscope-energy dispersive X-ray spectrometer (TEM-EDX).

The intermediate layer 14 may have a one-layer configuration or a configuration of two or more layers. When the intermediate layer 14 has a one-layer configuration, the intermediate layer 14 is preferably composed of a layer containing a metal composed of Cu, Al, Ti, Ni, or a combination thereof (for example, an alloy or an intermetallic compound) and is more preferably Al, Ti, or a combination thereof (for example, an alloy or an intermetallic compound), further preferably a layer mainly containing Al or a layer mainly containing Ti. On the other hand, if a metal or an alloy that does not have sufficiently high adhesion with the carrier 12 is used for the intermediate layer 14, as shown in Figure 1, the intermediate layer 14 preferably has a two-layer configuration composed of a first intermediate layer 14a and a second intermediate layer 14b in order closest to the carrier 12. That is, adhesion with the carrier 12 can be improved by providing a layer composed of a metal (for example, Ti) or an alloy that has excellent adhesion to the carrier 12 as the first intermediate layer 14a adjacent to the carrier 12, and providing a layer composed of a metal (for example, Cu) or an alloy that has poor adhesion to the carrier 12 as the second intermediate layer 14b adjacent to the release layer 16. Therefore, examples of a preferred two-layer configuration of the intermediate layer 14 include a laminated structure composed of a Ti-containing layer adjacent to the carrier 12, and a Cu-containing layer adjacent to the release layer 16. When the constituent elements and balance of thicknesses of the layers of the two-layer configuration are changed, the release strength also changes, and therefore the constituent elements and thicknesses of the layers are preferably appropriately adjusted. The category of the "metal M-containing layer" herein also includes alloys comprising an element other than the metal M in a range that does not impair the releasability of the carrier. Therefore, the intermediate layer 14 can also be referred to as a layer mainly comprising the metal M. In the above respect, the content of the metal M in the intermediate layer 14 is preferably 50 atomic % or more and 100 atomic % or less, more preferably 60 atomic % or more and 100 atomic % or less, further preferably 70 atomic % or more and 100 atomic % or less, particularly preferably 80 atomic % or more and 100 atomic % or less, and most preferably 90 atomic % or more and 100 atomic % or less.

When the intermediate layer 14 is composed of an alloy, examples of preferred alloys include Ni alloys. The Ni alloy preferably has a Ni content of 45% by weight or more and 98% by weight or less, more preferably 55% by weight or more and 90% by weight or less, and further preferably 65% by weight or more and 85% by weight or less. A preferred Ni alloy is an alloy of Ni and at least one selected from the group consisting of Cr, W, Ta, Co, Cu, Ti, Zr, Si, C, Nd, Nb, and La, more preferably an alloy of Ni and at least one selected from the group consisting of Cr, W, Cu, and Si. When the intermediate layer 14 is a Ni alloy layer, it is particularly preferably a layer formed by a magnetron sputtering method using a Ni alloy target, from the viewpoint of the uniformity of film thickness distribution.

The release layer 16 is a layer that allows or facilitates the release of the carrier 12, and the intermediate layer 14 when it is present. The release layer 16 may be either an organic release layer or an inorganic release layer, and may be a layer that can be released by a laser release method (laser lift-off, LLO). When the release layer 16 is composed of a material that can be released by laser lift-off, the release layer 16 may be composed of a resin having an interfacial adhesive strength that is reduced by laser beam irradiation after curing, or may be a layer of silicon, silicon carbide, or the like that is modified by laser beam irradiation. Examples of the organic component used when the release layer 16 is an organic release layer include a nitrogen-containing organic compound, a sulfur-containing organic compound, and a carboxylic acid. Examples of the nitrogen-containing organic compounds include triazole compounds and imidazole compounds. On the other hand, examples of the inorganic component used for the inorganic release layer include metal oxides or metal oxynitrides comprising at least one or more of Ni, Mo, Co, Cr, Fe, Ti, W, P, Zn, Cu, Al, Nb, Zr, Ta, Ag, In, Sn, and Ga, or a carbon layer. Among these, particularly, the release layer 16 is preferably a carbon-containing layer, that is, a layer mainly comprising carbon, in terms of ease of release, film-forming properties, and the like, more preferably a layer mainly composed of carbon or a hydrocarbon, and further preferably a layer composed of amorphous carbon, a hard carbon film. In this case, the release layer 16 (that is, a carbon-containing layer) preferably has a carbon concentration of 60 atomic % or more, more preferably 70 atomic % or more, further preferably 80 atomic % or more, and particularly preferably 85 atomic % or more as measured by XPS. The upper limit value of the carbon concentration is not particularly limited and may be 100 atomic % but is practically 98 atomic % or less. The release layer 16 can comprise unavoidable impurities (for example, oxygen and hydrogen derived from the surrounding environment such as an atmosphere). In the release layer 16, metal atoms of types other than the metal contained as the release layer 16 can be mixed due to the film formation method of the functional layer 17 or the metal layer 18. When a carbon-containing layer is used as the release layer 16, the interdiffusivity and reactivity with the carrier are low, and even if the carrier-attached metal foil 10 is subjected to pressing at a temperature of more than 300°C, the formation of metallic bonds between the metal layer and the bonding interface due to high temperature heating can be prevented to maintain a state in which the release and removal of the carrier is easy. This release layer 16 is also preferably a layer formed by a vapor phase method such as sputtering, in terms of suppressing excessive impurities in the release layer 16, and in terms of continuous productivity with the film formation of the optionally provided intermediate layer 14, and the like. The thickness when a carbon-containing layer is used as the release layer 16 is preferably 1 nm or more and 20 nm or less, more preferably 1 nm or more and 10 nm or less. By setting such a thickness, a release layer having a roughness equivalent to that of the carrier and having a release function can be provided. This thickness is a value measured by analyzing a layer cross section by a transmission electron microscope-energy dispersive X-ray spectrometer (TEM-EDX).

The release layer 16 may comprise each layer of a metal oxide layer and a carbon-containing layer or be a layer comprising both a metal oxide and carbon. Particularly, when the carrier-attached metal foil 10 comprises the intermediate layer 14, the carbon-containing layer can contribute to the stable release of the carrier 12, and the metal oxide layer can suppress the diffusion of the metal elements derived from the intermediate layer 14 and the metal layer 18, accompanying heating. As a result, even after the carrier-attached metal foil 10 is heated at a temperature as high as, for example, 350°C or more, stable releasability can be maintained. The metal oxide layer is preferably a layer comprising an oxide of a metal composed of Cu, Ti, Al, Nb, Zr, Cr, W, Ta, Co, Ag, Ni, In, Sn, Zn, Ga, Mo, or a combination thereof. The metal oxide layer is particularly preferably a layer formed by a reactive sputtering method in which sputtering is performed under an oxidizing atmosphere, using a metal target, in terms of being able to easily control film thickness by the adjustment of film formation time. The thickness of the metal oxide layer is preferably 0.1 nm or more and 100 nm or less. The upper limit value of the thickness of the metal oxide layer is more preferably 60 nm or less, further preferably 30 nm or less, and particularly preferably 10 nm or less. This thickness is a value measured by analyzing a layer cross section by a transmission electron microscope-energy dispersive X-ray spectrometer (TEM-EDX). At this time, the order in which the metal oxide layer and the carbon layer are laminated as the release layer 16 is not particularly limited. The release layer 16 may be present in a state of a mixed phase in which the boundary between the metal oxide layer and the carbon-containing layer is not clearly identified (that is, a layer comprising both a metal oxide and carbon).

Similarly, from the viewpoint of maintaining stable releasability even after heat treatment at high temperature, the release layer 16 may be a metal-containing layer in which the surface on the side adjacent to the metal layer 18 is a fluorination-treated surface and/or a nitriding-treated surface. In the metal-containing layer, a region in which the sum of the content of fluorine and the content of nitrogen is 1.0 atomic % or more (hereinafter referred to as a "(F + N) region") is preferably present over a thickness of 10 nm or more, and the (F + N) region is preferably present on the metal layer 18 side of the metal-containing layer. The thickness (in terms of SiOz) of the (F + N) region is a value specified by performing the depth profile elemental analysis of the carrier-attached metal foil 10 using XPS. The fluorination-treated surface or the nitriding-treated surface can be preferably formed by Reactive ion etching (RIE) or a reactive sputtering method. On the other hand, the metal element included in the metal-containing layer preferably has a negative standard electrode potential. Preferred examples of the metal element included in the metal-containing layer include Cu, Ag, Sn, Zn, Ti, Al, Nb, Zr, W, Ta, Mo, and combinations thereof (for example, alloys and intermetallic compounds). The content of the metal element in the metal-containing layer is preferably 50 atomic % or more and 100 atomic % or less. The metal-containing layer may be a single layer composed of one layer or a multilayer composed of two or more layers. The thickness of the entire metal-containing layer is preferably 10 nm or more and 1000 nm or less, more preferably 30 nm or more and 500 nm or less, further preferably 50 nm or more and 400 nm or less, and particularly preferably 100 nm or more and 300 nm or less. The thickness of the metal-containing layer itself is a value measured by analyzing a layer cross section by a transmission electron microscope-energy dispersive X-ray spectrometer (TEM-EDX).

Alternatively, the release layer 16 may be a metal oxynitride-containing layer instead of the carbon layer and the like. The surface of the metal oxynitride-containing layer opposite to the carrier 12 (that is, on the metal layer 18 side) preferably comprises at least one metal oxynitride selected from the group consisting of TaON, NiON, TiON, NiWON, and MoON. In terms of ensuring the adhesion between the carrier 12 and the metal layer 18, the surface of the metal oxynitride-containing layer on the carrier 12 side preferably comprises at least one selected from the group consisting of Cu, Ti, Ta, Cr, Ni, Al, Mo, Zn, W, TiN, and TaN. Thus, the number of foreign matter particles on the metal layer 18 surface is suppressed to improve circuit-forming properties, and even after the carrier-attached metal foil 10 is heated at high temperature for a long time, stable release strength can be maintained. The thickness of the metal oxynitride-containing layer is preferably 5 nm or more and 500 nm or less, more preferably 10 nm or more and 400 nm or less, further preferably 20 nm or more and 200 nm or less, and particularly preferably 30 nm or more and 100 nm or less. This thickness is a value measured by analyzing a layer cross section by a transmission electron microscope-energy dispersive X-ray spectrometer (TEM-EDX).

Optionally, the functional layer 17 may be provided between the release layer 16 and the metal layer 18. The functional layer 17 is not particularly limited as long as it provides the desired functions such as an etching stopper function and an antireflection function to the carrier-attached metal foil 10. Preferred examples of the metal constituting the functional layer 17 include Ti, Al, Nb, Zr, Cr, W, Ta, Co, Ag, Ni, Mo, and combinations thereof, more preferably Ti, Zr, Al, Cr, W, Ni, Mo, and combinations thereof, further preferably Ti, Al, Cr, Ni, Mo, and combinations thereof, and particularly preferably Ti, Mo, and combinations thereof. These elements have the property of not dissolving in flash etchants (for example, copper flash etchants) and, as a result, can exhibit excellent chemical resistance to flash etchants. Therefore, the functional layer 17 is a layer less likely to be etched with a flash etchant than the metal layer 18, and therefore can function as an etching stopper layer. In addition, the metal constituting the functional layer 17 also has the function of preventing the reflection of light, and therefore the functional layer 17 can also function as an antireflection layer for improving visibility in image inspection (for example, automatic image inspection (AOI)). The functional layer 17 may be a pure metal or an alloy. The metal constituting the functional layer 17 may comprise unavoidable impurities due to the raw material component, the film formation step, and the like. The upper limit of the content of the metal is not particularly limited and may be 100 atomic %. The functional layer 17 is preferably a layer formed by a physical vapor deposition (PVD) method, more preferably a layer formed by sputtering. The thickness of the functional layer 17 is preferably 1 nm or more and 500 nm or less, more preferably 10 nm or more and 400 nm or less, further preferably 30 nm or more and 300 nm or less, and particularly preferably 50 nm or more and 200 nm or less.

The metal layer 18 is a layer composed of a metal. Preferred examples of the metal constituting the metal layer include Cu, Au, Pt, and combinations thereof (for example, alloys and intermetallic compounds), more preferably Cu alloy or Cu. The metal constituting the metal layer 18 may comprise unavoidable impurities due to the raw material component, the film formation step, and the like. The metal layer 18 may be manufactured by any method and may be a metal layer formed, for example, by wet film formation methods such as an electroless metal plating method and an electrolytic metal plating method, physical vapor deposition (PVD) methods such as sputtering and vacuum deposition, chemical vapor film formation, or combinations thereof. The metal layer 18 is particularly preferably a metal layer formed by physical vapor deposition (PVD) methods such as a sputtering method and vacuum deposition, from the viewpoint of being easily adapted to a fine pitch due to super-thinning, and most preferably a metal layer manufactured by a sputtering method. The metal layer 18 is preferably a non-roughened metal layer, but may be one in which secondary roughening occurs by preliminary roughening, soft etching treatment, rinse treatment, or oxidation-reduction treatment, as long as wiring pattern formation during printed wiring board manufacture is not hindered. From the viewpoint of being adapted to a fine pitch as described above, the thickness of the metal layer 18 is 0.01 µm or more and 4.0 µm or less, preferably 0.02 µm or more and 3.0 µm or less, more preferably 0.05 µm or more and 2.5 µm or less, further preferably 0.10 µm or more and 2.0 µm or less, particularly preferably 0.20 µm or more and 1.5 µm or less, and most preferably 0.30 µm or more and 1.2 µm or less. This thickness is a value measured by analyzing a layer cross section by a transmission electron microscope-energy dispersive X-ray spectrometer (TEM-EDX). The metal layer 18 having a thickness within such a range is preferably manufactured by a sputtering method from the viewpoint of maintaining the in-plane uniformity of film formation thickness, and improving productivity in a sheet form or a roll form.

The outermost surface on the first surface 12a of the metal layer 18 preferably has a flat shape corresponding to the surface shape of the flat region F of the carrier 12, and an uneven shape corresponding to the surface shape of the uneven region R of the carrier 12. In other words, as shown in Figures 1, the metal layer 18 is formed, via the intermediate layer 14 (when present), the release layer 16, and the functional layer 17 (when present), on the carrier 12 having the flat region F and the uneven region R, and thus the surface profiles of the flat region F and uneven region R of the carrier 12 are transferred to the surfaces of the layers. Thus, desirable surface profiles corresponding to the shapes of the regions of the carrier 12 are preferably provided to the outermost surface of the metal layer 18 while the uneven shape is transferred to part of the release layer 16. Thus, it is possible to still further prevent the release of the metal layer 18 when the carrier-attached metal foil 10 is cut, and it is possible to be still further adapted to a fine pitch. Typically, the surface having the flat shape corresponding to the flat region F of the carrier 12 (that is, the flat surface) on the outermost surface of the metal layer 18 has a developed interfacial area ratio Sdr of less than 5%, preferably 0.01% or more and 4.0% or less, more preferably 0.03% or more and 3.0% or less, further preferably 0.05% or more and 1.0% or less, and particularly preferably 0.08% or more and 0.50% or less. The surface having the uneven shape corresponding to the uneven region R of the carrier 12 (that is, the uneven surface) on the outermost surface of the metal layer 18 typically has a developed interfacial area ratio Sdr of 3% or more and 39% or less, preferably 3.5% or more and 35% or less, more preferably 4.0% or more and 30% or less, further preferably 4.5% or more and 25% or less, and particularly preferably 5% or more and 15% or less.

The metal layer 18 extends from the first surface 12a to the side face 12c of the carrier so that at least a portion of the side face 12c of the carrier is covered. It is preferred that the entire side face 12c of the carrier is covered by the metal layer 18. In any case, as described above, the uneven region R encompasses the region of the side face 12c covered by the metal layer 18. Optionally, the functional layer 17, release layer 16 and/or intermediate layer 14 may also extend from the first surface 12a to the side face 12c of the carrier. When the release layer 16 extends to the side face 12c, from the viewpoint of effectively suppressing chemical solution infiltration from the end of the release layer 16, it is preferred that the metal layer 18 (and optionally the functional layer 17) extends to the side face 12c so as to cover the release layer 16. In addition, the thickness of each of the intermediate layer 14, the release layer 16, the functional layer 17, and the metal layer 18 described above refers to the thickness of each layer provided on the first surface 12a. That is, the thickness of each layer provided on the side face 12c may deviate from the above-described thickness ranges. For example, it is permissible for the thickness of the metal layer 18 provided on the side face 12c to deviate from the range of 0.01 µm or more and 4.0 µm or less. The thickness of the metal layer 18 on the side face 12c is not particularly limited, but is typically 0.02 µm or more and 3 µm or less, more typically 0.04 µm or more and 2 µm or less, and further typically 0.05 µm or more and 0.8 µm or less.

The intermediate layer 14 (when present), the release layer 16, the functional layer 17 (when present), and the metal layer 18 are all preferably physical vapor-deposited (PVD) films, that is, films formed by a physical vapor deposition (PVD) method, more preferably sputtered films, that is, films formed by a sputtering method.

The thickness of the entire carrier-attached metal foil 10 is not particularly limited but is preferably 500 µm or more and 3000 µm or less, more preferably 700 µm or more and 2500 µm or less, further preferably 900 µm or more and 2000 µm or less, and particularly preferably 1000 µm or more and 1700 µm or less. The size of the carrier-attached metal foil 10 is not particularly limited but is preferably 10 cm square or more, more preferably 20 cm square or more, and further preferably 25 cm square or more. The upper limit of the size of the carrier-attached metal foil 10 is not particularly limited, and an example of one rough standard of the upper limit includes 1000 cm square. The carrier-attached metal foil 10 is in a form in which the carrier-attached metal foil 10 itself can be handled alone, before and after the formation of wiring.

Optionally, the carrier-attached metal foil 10 may further have a redistribution layer 20 on the metal layer 18. Herein, a redistribution layer means a layer including an insulating layer and a wiring layer formed inside and/or on the surface of the insulating layer. When the carrier-attached metal foil 10 is seen in plan view, it is preferred that at least a portion of the redistribution layer 20 reaches the end of the carrier 12 (the boundary portion between the first surface 12a and the side face 12c), and it is more preferred that the entire peripheral portion of the redistribution layer 20 reaches the end of the carrier 12. Further, as shown in Figure 1, it is preferred that at least a portion of the end (typically the insulating layer) of the redistribution layer 20 is located on the uneven region R, and it is more preferred that the entire peripheral portion of the redistribution layer 20 is located on the uneven region R. By doing so, the adhesion between the metal layer 18 and the redistribution layer 20 can be improved. As a result, in the processes that use a chemical solution during and after the formation of the redistribution layer 20, infiltration of the chemical solution between the metal layer 18 and the redistribution layer 20 is suppressed, and unintended release between both of those layers can also be effectively prevented. As shown in Figure 1, when the carrier-attached metal foil 10 is viewed in cross section, the length of overlap between the peripheral portion of the redistribution layer 20 and the uneven region R (the width of the redistribution layer 20 located on the uneven region R) is preferably 0.1 mm or more and 50 mm or less, more preferably 0.2 mm or more and 45 mm or less, further preferably 0.3 mm or more and 40 mm or less, still further preferably 1.0 mm or more and 40 mm or less, particularly preferably 1.5 mm or more and 40 mm or less, more particularly preferably 2.0 mm or more and 40 mm or less, and most preferably 2.5 mm or more and 35 mm or less.

The carrier-attached metal foil 10 may be a structure in which the above-described various layers are sequentially provided on both sides of the carrier 12 so as to be vertically symmetrical. That is, the carrier-attached metal foil 10 may further comprise a second release layer provided on the second surface 12b of the carrier, and a second metal layer having a thickness of 0.01 µm or more and 4.0 µm or less provided on the second release layer. In this case, it is preferred that the second metal layer extends from the second surface 12b to the side face 12c of the carrier so that at least a portion of the side face 12c of the carrier is covered by the second metal layer. Moreover, it is preferred that the carrier 12 further has the above-described uneven region R on the second surface 12b, and that the uneven region R encompasses the region of the side face 12c covered by the second metal layer. In addition, the carrier-attached metal foil 10 may further have an additional intermediate layer between the second surface 12b of the carrier and the second release layer, and a second functional layer between the second release layer and the second metal layer. The carrier-attached metal foil 10 may further have a second redistribution layer on the second metal layer. Preferred aspects regarding the first surface 12a, intermediate layer 14, release layer 16, functional layer 17, metal layer 18, and redistribution layer 20 of the carrier described above also apply as is to each of the second surface 12b, additional intermediate layer, second release layer, second functional layer, second metal layer, and second redistribution layer of the carrier. The various layers provided on the second surface 12b of the carrier may be formed by continuously forming films from the first surface 12a to the second surface 12b of the carrier. That is, the intermediate layer 14 and the additional intermediate layer, the release layer 16 and the second release layer, the functional layer 17 and the second functional layer, and/or the metal layer 18 and the second metal layer may be connected to each other via the side face 12c of the carrier.

### Method for Manufacturing Carrier-Attached Metal Foil

The carrier-attached metal foil 10 of the present invention can be manufactured by (1) providing a carrier, (2) performing roughening treatment on at least the side face of the carrier, (3) forming various layers such as a release layer and a metal layer on the carrier, and (4) optionally forming a redistribution layer on the metal layer.

### (1) Provision of Carrier

First, the carrier 12 is provided. This carrier 12 preferably has a flat surface having with an Sdr of less than 5% on at least one surface. This Sdr is preferably 0.01% or more and 4.0% or less, more preferably 0.03% or more and 3.0% or less, further preferably 0.05% or more and 1.0% or less, particularly preferably 0.07% or more and 0.50% or less, and most preferably 0.08% or more and 0.50% or less. Generally, substrates of SiO₂, SiN, Si single crystals, and Si polycrystals, and glass products in a plate form are excellent in flatness, and therefore commercially available SiOz substrates, SiN substrates, Si single crystal substrates, Si polycrystalline substrates, glass sheets, glass films, and glass plates having a flat surface satisfying Sdr within the range may be used as the carrier 12. Alternatively, by subjecting a carrier 12 surface not satisfying the Sdr to polishing processing by a known method, Sdr within the range may be provided. Preferred materials and characteristics of the carrier 12 are as described above.

### (2) Roughening treatment of Carrier Surface

Next, roughening treatment is performed on at least the side face 12c of the carrier to form an uneven region R having an Sdr of 3% or more and 39% or less. This Sdr is preferably 3.5% or more and 35% or less, more preferably 4.0% or more and 30% or less, further preferably 4.5% or more and 25% or less, and particularly preferably 5% or more and 15% or less. In addition to the roughening treatment of the side face 12c, it is preferred to perform roughening treatment on a predetermined region of the first surface 12a of the carrier so that the uneven region R surrounds the flat surface on the first surface 12a of the carrier. The roughening treatment should be performed according to a known method, and is not particularly limited as long as the Sdr within the above range can be achieved, and the uneven region R can be formed in the desired pattern (using masking in combination, as needed). A preferred roughening treatment method is blasting treatment or etching treatment, more preferably blasting treatment, in terms of being able to efficiently form the uneven region R having the desired Sdr.

Roughening treatment by blasting treatment can be performed by projecting a particulate medium M (projection material) onto the side face portion 12c and/or a predetermined region of the first surface 12a (that is, a region in which the uneven region R is to be formed) of the carrier from a nozzle. A preferred size of the nozzle is a width of 0.1 mm or more and 20 mm or less and a length of 100 mm or more and 1000 mm or less, more preferably a width of 3 mm or more and 15 mm or less and a length of 200 mm or more and 800 mm or less, when the discharge port is rectangular. On the other hand, when the discharge port is circular, a preferred size of the nozzle is a diameter of 0.2 mm or more and 50 mm or less, more preferably a diameter of 3 mm or more and 20 mm or less. The particle diameter of the medium is preferably 7 µm or more and 50 µm or less, more preferably 8 µm or more and 35 µm or less. Preferred examples of the material of the medium include alumina, zirconia, silicon carbide, iron, aluminum, zinc, glass, steel, and boron carbide. The Mohs hardness of the medium is preferably 4 or more, more preferably 5.5 or more, and further preferably 6.0 or more. Particularly, by using such a medium, the uneven region R in which the desired Sdr is controlled within the above range can be formed on the surface of the carrier 12. A preferred medium discharge pressure is 0.01 MPa or more and 0.80 MPa or less, more preferably 0.1 MPa or more and 0.50 MPa or less, and further preferably 0.15 MPa or more and 0.25 MPa or less. The blasting treatment time per unit area for the carrier 12 is preferably 0.03 seconds/cm² or more and 10 seconds/cm² or less, more preferably 0.1 seconds/cm² or more and 5 seconds/cm² or less. Particularly, in terms of easily forming the uneven region R in which the Sdr is controlled within the above range, it is preferred that the medium is mixed with water into the form of a slurry, and this slurry is discharged from the nozzle by pressurized air to perform blasting treatment. By performing roughening treatment (blasting treatment) under the above-described conditions, a decrease in the strength of the carrier after the roughening treatment can be more effectively suppressed.

On the other hand, preferred examples of roughening treatment by etching treatment include a wet process using a solution comprising hydrofluoric acid, and a dry process by Reactive ion etching (RIE) using a process gas comprising fluorine (for example, CF₄ or SF₆).

In order to selectively perform roughening treatment (especially blasting treatment or etching treatment) on the desired region, masking is preferably used. Specifically, a masking layer is preferably formed on portions other than the predetermined region of the side face portion 12c and/or the first surface 12a (that is, a region in which the uneven region R is to be formed) of the carrier before the roughening treatment. In this case, it is desirable to remove the masking layer after the roughening treatment so that the formation of the various layers in the subsequent steps can be performed more smoothly.

### (3) Formation of Various Layers on Carrier

Optionally the intermediate layer 14, the release layer 16, optionally the functional layer 17, and the metal layer 18 having a thickness of 0.01 µm or more and 4.0 µm or less are formed on the first surface 12a of the carrier on which the roughening treatment is performed. The formation of each layer of the intermediate layer 14 (when present), the release layer 16, the functional layer 17 (when present), and the metal layer 18 is preferably performed by a physical vapor deposition (PVD) method from the viewpoint of being easily adapted to a fine pitch due to super-thinning. Examples of the physical vapor deposition (PVD) method include a sputtering method, a vacuum deposition method, and an ion plating method, and most preferably a sputtering method in terms of being able to control film thickness in a wide range such as 0.05 nm or more and 5000 nm or less, and in terms of being able to ensure film thickness uniformity over a wide width or area, and the like. Particularly, by forming all layers of the intermediate layer 14 (when present), the release layer 16, the functional layer 17 (when present), and the metal layer 18 by the sputtering method, the manufacturing efficiency increases significantly. The film formation by the physical vapor deposition (PVD) method should be performed according to known conditions using a known vapor phase film formation apparatus, and is not particularly limited. For example, film formation may be performed by adopting the film formation conditions for the various layers by physical vapor deposition (PVD) method disclosed in Patent Literature 7 (WO2019/163605) as is, or by appropriately changing those conditions. For example, when the sputtering method is adopted, the sputtering method may include various known methods such as magnetron sputtering, a bipolar sputtering method, and a facing target sputtering method, but magnetron sputtering is preferred in terms of a fast film formation rate and high productivity. The sputtering may be performed with either of DC (direct current) and RF (radio frequency) power supplies. Also for the target shape, a widely known plate type target can be used, but a cylindrical target is desirably used from the viewpoint of target use efficiency.

### (4) Formation of Redistribution Layer (Optional Step)

A redistribution layer 20 may optionally be formed on the metal layer 18 of the carrier-attached metal foil 10. The redistribution layer 20 may be formed by a known method, and the method is not particularly limited. For example, the redistribution layer 20 can be preferably formed by alternately stacking insulating layers and wiring layers to form a multilayer structure using a coreless buildup method.

After the redistribution layer 20 is formed, a chip may be mounted on the carrier-attached metal foil 10 and sealed with a mold resin. The chip mounting and resin sealing may be performed by known methods, and the methods are not particularly limited. Further, the carrier 12 (and the intermediate layer 14 if present) may be released after resin sealing, and the exposed metal layer 18 (and the functional layer 17 if present) may be etched away after release. The carrier 12 may be released as follows. First, a cut is made in the thickness direction from the surface of the carrier-attached metal foil 10 opposite to the carrier 12 (typically the mold resin side), and the various layers except the carrier 12 are defined into a center portion (the portion containing the chip) and a peripheral portion. Then, with the center portion fixed, the center portion including the metal layer 18 and the redistribution layer 20 is released from the carrier 12 by pushing down the peripheral portion using a pressing member or the like. By doing so, the carrier 12 can be released easily.

### EXAM PLES

The present invention will be more specifically described by the following Examples.

### Examples A1 to A11

As shown in Figure 1, a carrier made of glass or single crystal silicon was provided as a carrier 12. An uneven region R was formed on this carrier, and then a first intermediate layer 14a, a second intermediate layer 14b, a release layer 16, a functional layer 17, and a metal layer 18 were formed in this order to fabricate a carrier-attached metal foil 10. The specific procedure is as follows.

The Sdr mentioned in the following Examples is a value measured by a laser microscope (manufactured by Olympus Corporation, LEXT OLS5000) in accordance with ISO 25178. Specifically, the surface profile of a 258.346 µm × 258.348 µm region on the surface of the measurement target was measured using the laser microscope described above using a 50× magnification objective lens. The Sdr was calculated for the obtained surface profile by surface property analysis using analysis software (LEXT OLS5100 analysis application by Olympus Corporation). At this time, the cutoff wavelength by the S filter was set to 0.8 µm, and no cutoff was performed by the L filter.

### (1) Provision of Carrier

A 300 mm diameter, 1.1 mm thick disc-shaped carrier 12 having a first surface 12a and a second surface 12b facing each other, and a curved shape side face 12c connecting these surfaces, was provided. The type of this carrier 12 was a glass carrier (soda lime glass, manufactured by Central Glass Co., Ltd., Sdr at first surface 12a: 0.10%) for Examples A1 to A4 and A9 to A11, and a single crystal silicon carrier (manufactured by Trinity, Inc., Sdr at first surface 12a: 0.10%) was used for Examples A5 to A8.

### (2) Roughening Treatment of Carrier

A masking layer was formed on a first surface 12a of the carrier so as to cover the portion other than the periphery (width 1 mm) of the first surface 12a. The formation of this masking layer was performed by cutting a cutting sheet (manufactured by LINTEC Corporation, PVC100M M11K) to a diameter of 298 mm using a cutting plotter, and laminating the cut sheet on the first surface 12a of the carrier so that the centers of the cutting sheet and the carrier overlap. Next, a medium (manufactured by Fuji Manufacturing Co., Ltd., white fused alumina) having the average particle diameter D50 shown in Table 1 for each of Examples A1 to A10 was projected at a condition of a discharge pressure of 0.4 MPa onto the first surface 12a and side face 12c of the carrier partially covered with the masking layer, using a blasting apparatus (manufactured by Fuji Manufacturing Co., Ltd., product number: SCM-4RBT-05-401), to perform roughening treatment on the carrier 12. At this point, the blasting treatment time per unit area for the carrier 12 was 0.33 seconds/cm². Further, the roughening treatment of the side face 12c was carried out in a range of up to 0.6 mm in the thickness direction from the first surface 12a toward the second surface 12b, and the roughening treatment was performed over the entire circumference of the side face 12c. Thus, an uneven region R was continuously formed from the side face 12c of the carrier to the periphery of the first surface 12a. Then, the masking layer was removed to expose flat region F. The Sdr of the uneven region R in the carrier 12 after the roughening treatment was as shown in Table 1. It is noted that in Example A11, the carrier 12 was not subjected to roughening treatment.

### (3) Formation of First Intermediate Layer

A 100 nm thick Ti layer as the first intermediate layer 14a was formed on the first surface 12a and the side face portion 12c of the carrier, by sputtering with the following apparatus and conditions:
- Apparatus: single-wafer magnetron sputtering apparatus (manufactured by Canon Tokki Corporation, MLS464)
- Target: Ti target (purity 99.999%) having diameter of 8 inches (203.2 mm)
- Ultimate vacuum: less than 1 × 10⁻⁴ Pa
- Carrier gas: Ar (flow rate: 100 sccm)
- Sputtering pressure: 0.35 Pa
- Sputtering power: 1000 W (3.1 W/cm²)
- Temperature during film formation: 40°C

### (4) Formation of Second Intermediate Layer

A 100 nm thick Cu layer as the second intermediate layer 14b was formed on the first intermediate layer 14a by sputtering with the following apparatus and conditions:
- Apparatus: single-wafer DC sputtering apparatus (manufactured by Canon Tokki Corporation, MLS464)
- Target: Cu target (purity 99.98%) having diameter of 8 inches (203.2 mm)
- Ultimate vacuum: less than 1 × 10⁻⁴ Pa
- Carrier gas: Ar (flow rate: 100 sccm)
- Sputtering pressure: 0.35 Pa
- Sputtering power: 1000 W (6.2 W/cm²)
- Temperature during film formation: 40°C

### (5) Formation of Release Layer

A 6 nm thick amorphous carbon layer as the release layer 16 was formed on the second intermediate layer 14b by sputtering with the following apparatus and conditions:
- Apparatus: single-wafer DC sputtering apparatus (manufactured by Canon Tokki Corporation, MLS464)
- Target: carbon target (purity 99.999%) having diameter of 8 inches (203.2 mm)
- Ultimate vacuum: less than 1 × 10⁻⁴ Pa
- Carrier gas: Ar (flow rate: 100 sccm)
- Sputtering pressure: 0.35 Pa
- Sputtering power: 250 W (0.7 W/cm²)
- Temperature during film formation: 40°C

### (6) Formation of Functional Layer

A 100 nm thick Ti layer as the functional layer 17 was formed on the surface of the release layer 16 by sputtering with the following apparatus and conditions:
- Apparatus: single-wafer DC sputtering apparatus (manufactured by Canon Tokki Corporation, MLS464)
- Target: Ti target (purity 99.999%) having diameter of 8 inches (203.2 mm)
- Carrier gas: Ar (flow rate: 100 sccm)
- Ultimate vacuum: less than 1 × 10⁻⁴ Pa
- Sputtering pressure: 0.35 Pa
- Sputtering power: 1000 W (3.1 W/cm²)

### (7) Formation of Metal Layer

A Cu layer having a thickness of 300 nm as the metal layer 18 was formed on the functional layer 17 by sputtering with the following apparatus and conditions to obtain the carrier-attached metal foil 10. At this time, the metal layer 18 was formed to cover the side face 12c and release layer 16 of the carrier.
- Apparatus: single-wafer DC sputtering apparatus (manufactured by Canon Tokki Corporation, MLS464)
- Target: Cu target (purity 99.98%) having diameter of 8 inches (203.2 mm)
- Ultimate vacuum: less than 1 × 10⁻⁴ Pa
- Carrier gas: Ar (flow rate: 100 sccm)
- Sputtering pressure: 0.35 Pa
- Sputtering power: 1000 W (3.1 W/cm²)
- Temperature during film formation: 40°C

### (8) Measurement of Release Strength of Uneven Region

A carrier-attached metal foil in which the entire first surface 12a was an uneven region was fabricated in the same manner as in (1) to (7) above, except that a masking layer was not formed and the side face 12c was not subjected to roughening treatment. 18 µm of Cu was laminated on the metal layer side of this carrier-attached metal foil by electrolytic plating to obtain a measurement sample. For this measurement sample, the release strength (gf/cm) when the electrolytic plating Cu layer was released was measured in accordance with JIS Z 0237-2009 under the conditions of a measurement width of 10 mm, a measurement length of 17 mm, and a release rate of 50 mm/minute. The release strength of the uneven region thus measured was as shown in Table 1.

### Various Evaluations

The carrier-attached metal foils 10 obtained in Examples A1 to A11 were subjected to the following various evaluations.

### <Difference in Height of Stepped Portion>

Using a laser microscope (LEXT OLS5100, manufactured by Olympus Corporation), a region of 258.346 µm in length × 258.348 µm in width on the first surface 12a of the carrier-attached metal foil 10 was measured so that the boundary between the uneven region R and the flat region F was parallel to the vertical direction and aligned with the center in the horizontal direction. At this time, the magnification of the objective lens was set to 50 times. In this way, a cross-sectional profile of near the boundary between the uneven region R and the flat region F was obtained. By analyzing this cross-sectional profile using analysis software (LEXT OLS5100 analysis application, by Olympus Corporation), the horizontal height profile (vertical height of 0 µm to 258.346 µm was averaged) was calculated. In this horizontal height profile, the difference between the average height of the uneven region R portion and the average height of the flat region F portion was measured, and the difference was taken as the height difference of the stepped portion. The results were as shown in Table 1.

### <Release in Redistribution Layer Formation Process>

The presence or absence of release in the redistribution layer formation process and the chemical solution infiltration width were checked. Specifically, first, an insulating resin material (photosensitive insulating material) was laminated on the surface of the carrier-attached metal foil 10 on the metal layer 18 side and thermally cured at 230°C for 60 minutes to form a 10 µm thick insulating layer. Next, a Ti layer and a Cu layer were sputtered in this order onto the surface of the carrier-attached metal foil 10 on the insulating layer side. A photosensitive liquid resist was applied to the surface of the Cu layer, and exposed and developed to form a photoresist layer with a predetermined pattern. At this time, TMAH (tetramethylammonium hydroxide, manufactured by Tokyo Ohka Kogyo Co., Ltd., NMD-3, 2.38%) was used as a developer and was applied to the surface of the carrier-attached metal foil 10 using a spin coater. Then, patterned electrodeposited copper plating was performed on the exposed surface of the Cu layer (that is, on the portion not masked by the photoresist layer) to form an electrodeposited copper plating layer, and then the photoresist layer was stripped. At this time, the resist was stripped using ST-120 (manufactured by Tokyo Ohka Kogyo Co., Ltd.) as a stripping solution by immersing the carrier-attached metal foil 10 therein. After that, the exposed unnecessary portions of the copper layer and Ti layer were removed using a sulfuric acid-hydrogen peroxide-based etching solution and a hydrogen peroxide-based alkaline etching solution (manufactured by Meltex Inc., Melstrip TI-3991), respectively, to form a wiring layer having a thickness of 5 µm on the Cu layer. Then, an insulating resin material was laminated and thermally cured at 230°C for 60 minutes to form an insulating layer having a thickness of 10 µm. Next, a Ti layer and a Cu layer were sputtered in this order onto the surface of the carrier-attached metal foil 10 on the insulating layer side. In this way, the redistribution layer 20 was formed. During the formation process of this redistribution layer 20, it was checked whether natural release occurred between the carrier 12 and the metal layer 18. Further, the infiltration width of the chemical solutions used in the process was measured by observing the cross section of the redistribution layer 20 with an optical microscope, and evaluated according to the following criteria. The results were as shown in Table 1.

### (Evaluation Criteria for Chemical Solution Infiltration Width)

- Evaluation A: Chemical solution infiltration width of less than 0.1 mm (best)
- Evaluation B: Chemical solution infiltration width of 0.1 mm or more and less than 0.5 mm (good)
- Evaluation C: Chemical solution infiltration width of 0.5 mm or more (poor)
- Evaluation F: Measurement not possible due to release during the process

### [Table 1]

**Table 1**

| | Carrier type | Roughening treatment conditions | | Uneven region | | Difference in height of stepped portion (µm) | Evaluation of chemical solution infiltration width |
|---|---|---|---|---|---|---|---|
| | | Media average particle diameter D50 (µm) | Discharge pressure (MPa) | Sdr (%) | Release strength (gf/cm) | | |
| Ex. A1 | glass | 20.0±1.5 | 0.2 | 14 | 38.9 | 5 | A |
| Ex. A2 | glass | 20.0±1.5 | 0.4 | 21 | 76.4 | 11 | A |
| Ex. A3 | glass | 49.0±4.0 | 0.4 | 35 | 101.2 | 37 | A |
| Ex. A4 | glass | 14.0±1.0 | 0.4 | 7 | 25.3 | 4 | A |
| Ex. A5 | single crystal silicon | 49.0±4.0 | 0.2 | 19 | 60.9 | 10 | A |
| Ex. A6 | single crystal silicon | 30.0±2.0 | 0.4 | 14 | 26.0 | 12 | A |
| Ex. A7 | single crystal silicon | 14.0±1.0 | 0.4 | 8 | 12.0 | 6 | A |
| Ex. A8 | single crystal silicon | 14.0±1.0 | 0.2 | 5 | 9.0 | 3 | A |
| Ex. A9 | glass | 8.0±0.6 | 0.4 | 3 | 3.6 | 0.5 | B |
| Ex. A10* | glass | 8.0±0.6 | 0.2 | 2 | 1.3 | 0.05 | F |
| Ex. A11* | glass | (not subjected to roughening treatment) | | - | 1.4 | 0 | F |

| | | | | | | | |
|---|---|---|---|---|---|---|---|
| * Indicates a comparative example. | | | | | | | |

### Examples B1 to B6

These examples were experimental examples in which the relationship between developed interfacial area ratio Sdr and mechanical strength was verified when the carrier 12 was made of glass.

### (1) Provision of Carrier

A glass sheet 300 mm square and 1.1 mm thick having a flat surface having a developed interfacial area ratio Sdr of 0.10% (material: soda lime glass, manufactured by Nippon Sheet Glass Co., Ltd.) was provided.

### (2) Roughening Treatment of Carrier

A masking layer was formed on a carrier 12 surface so as to cover a portion other than the periphery (width 11 mm) of the carrier 12. The formation of this masking layer was performed by cutting a cutting sheet (PVC100M M11K, manufactured by LINTEC Corporation) to 278 mm square using a cutting plotter, and laminating the cut cutting sheet on a carrier 12 surface so that the centers of the cutting sheet and the carrier overlap. Next, a medium (manufactured by Fuji Manufacturing Co., Ltd., white fused alumina) having the average particle diameter D50 shown in Table 2 for each of Examples B1 to B6 was projected at the discharge pressure shown in Table 2 onto the carrier 12 surface partially covered with the masking layer, using a blasting apparatus (manufactured by Fuji Manufacturing Co., Ltd., product number: SCM-4RBT-05-401), to perform roughening treatment on the exposed portion of the carrier 12. Thus, an uneven region R was formed on the periphery (width 11 mm) of the carrier 12. Subsequently, the masking layer was removed to expose a flat region F. In this way, an uneven region R was formed on the surface of the carrier 12. Then, the masking layer was removed to expose the flat region F. The Sdr of the uneven region R in the carrier 12 after the roughening treatment was as shown in Table 2.

### Example B7 (Comparison)

The same glass sheet as provided in Examples B1 to B6 was used as a carrier 12 as it was, without performing the roughening treatment of the glass carrier.

### Evaluation

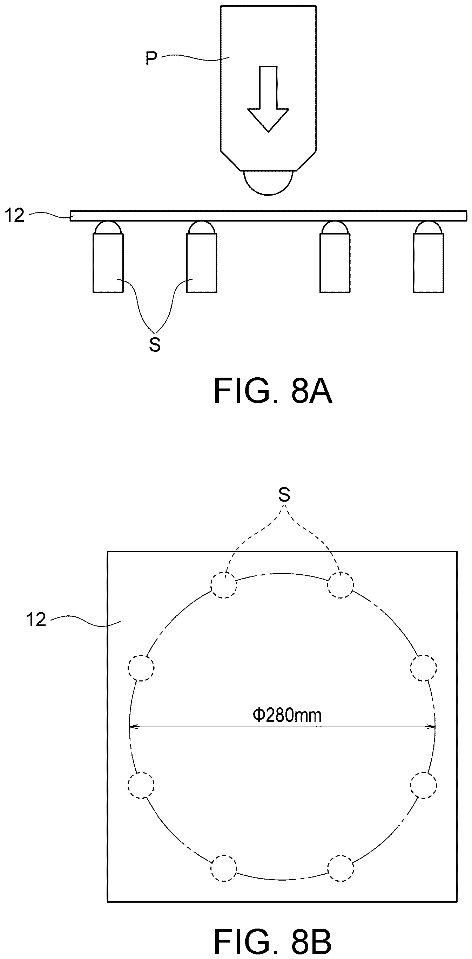

For the carriers 12 of Examples B1 to B7, the measurement of the breaking load was performed using a universal material tester (manufactured by Instron, product number: 5985). In other words, as shown in Figures 8A and 8B, the carrier 12 was placed on eight supporting members S (made of carbon steel for machine structural use S45C, quenching hardness: 50 HRC, radius of curvature of contact portion: 5 mm) disposed at equal intervals in a virtual circle having a diameter of 280 mm. Then, a pushing member P (made of high carbon chromium bearing steel SUJ2, quenching hardness: 67 HRC, radius of curvature of contact portion: 15 mm) was moved in the arrow direction in Figure 8A and pushed against the central portion of the carrier 12 to break the carrier 12. This measurement was performed on 10 carriers 12 for each Example. A Weibull plot (X axis: breaking load (N), Y axis: cumulative breakage probability (%)) was prepared from the obtained measurement data, and the average breaking load, the 10% breaking load (B10), and the shape parameter were calculated. The results were as shown in Table 2. Table 2 also shows together the percentages of the breaking loads of the glass carriers after the roughening treatment (Examples B1 to B6) to the breaking load of the untreated glass carrier (Example B7).

### [Table 2]

**Table 2**

| | Roughening treatment conditions | | | Breaking load of carrier | | | Average breaking load change rate (%)** | B10 change rate (%)** |
|---|---|---|---|---|---|---|---|---|
| | Media average particle diameter D50 (µm) | Discharge pressure (MPa) | Sdr (%) | Average breaking load (N) | B10 (N) | Shape parameter | | |
| Ex. B1* | 181±31 | 0.2 | 49 | 164.7 | 109.8 | 4.2 | 60.2 | 51.1 |
| Ex. B2* | 84.5±21.5 | 0.2 | 40 | 155.7 | 105.3 | 4.3 | 56.9 | 49.0 |
| Ex. B3 | 49.0±4.0 | 0.2 | 35 | 229.1 | 176.9 | 7.4 | 83.8 | 82.3 |
| Ex. B4 | 30.0±2.0 | 0.4 | 25 | 253.2 | 212.5 | 11.6 | 92.6 | 98.9 |
| Ex. B5 | 20.0±1.5 | 0.4 | 15 | 230.1 | 177.2 | 6.7 | 84.2 | 82.5 |
| Ex. B6 | 14.0±1.0 | 0.4 | 11 | 229.2 | 178.5 | 7.8 | 83.8 | 83.1 |
| Ex. B7* | none | - | - | 273.4 | 214.8 | 7.9 | 100 | 100 |

| | | | | | | | | |
|---|---|---|---|---|---|---|---|---|
| * Indicates a comparative example. ** Average breaking load and B10 are relative values (%) when the value of Ex. B7 using the untreated glass carrier is 100%. | | | | | | | | |

## Claims

1. A carrier-attached metal foil comprising:
a carrier having a first surface and a second surface facing each other, and a side face connected to the first surface and the second surface;
a release layer provided on the first surface of the carrier; and
a metal layer having a thickness of 0.01 µm or more and 4.0 µm or less provided on the release layer,
wherein the metal layer extends from the first surface to the side face of the carrier so that at least a portion of the side face is covered by the metal layer,
wherein the carrier has an uneven region having a developed interfacial area ratio Sdr of 3% or more and 39% or less as measured in accordance with ISO 25178 on the side face or the side face and the first surface, and
wherein the uneven region encompasses a region of the side face covered by the metal layer.

2. The carrier-attached metal foil according to claim 1, wherein the uneven region is provided over an entire circumference of the side face.

3. The carrier-attached metal foil according to claim 1 or 2,
wherein the carrier has a flat region having a developed interfacial area ratio Sdr of less than 5% as measured in accordance with ISO 25178 and the uneven region surrounding the flat region on the first surface, and
wherein the uneven region is provided continuously from the side face to the first surface of the carrier.

4. The carrier-attached metal foil according to claim 3, wherein, on the first surface of the carrier, a ratio of an area of the uneven region to a total area of the flat region and the uneven region is 0.01 or more and 0.5 or less.

5. The carrier-attached metal foil according to claim 3, wherein the uneven region is provided on the first surface in a pattern defining the flat region into two or more sections.

6. The carrier-attached metal foil according to claim 1 or 2,
wherein the carrier-attached metal foil has, on the uneven region, a stepped portion that is lower in height than a flat surface of the metal layer in the flat region, and
wherein a height difference between the stepped portion and the flat surface is more than 0.05 µm and 100 µm or less.

7. The carrier-attached metal foil according to claim 1 or 2, wherein the carrier has a micro-Vickers hardness of 500 HV or more and 3000 HV or less.

8. The carrier-attached metal foil according to claim 1 or 2, wherein the metal layer is composed of at least one metal selected from the group consisting of Cu, Au, and Pt.

9. The carrier-attached metal foil according to claim 1 or 2, further comprising an intermediate layer between the carrier and the release layer, the intermediate layer comprising at least one metal selected from the group consisting of Cu, Ti, Al, Nb, Zr, Cr, W, Ta, Co, Ag, Ni, In, Sn, Zn, Ga, and Mo.

10. The carrier-attached metal foil according to claim 1 or 2, further comprising a functional layer between the release layer and the metal layer, the functional layer being composed of at least one metal selected from the group consisting of Ti, Al, Nb, Zr, Cr, W, Ta, Co, Ag, Ni, and Mo.

11. The carrier-attached metal foil according to claim 1 or 2, wherein the carrier is a glass substrate comprising SiOz or a silicon substrate.

12. The carrier-attached metal foil according to claim 11, wherein the carrier is a glass substrate composed of at least one glass selected from the group consisting of quartz glass, borosilicate glass, alkali-free glass, soda lime glass, and aluminosilicate glass.

13. The carrier-attached metal foil according to claim 1 or 2, wherein the carrier in the uneven region has a release strength of 20 gf/cm or more and 3000 gf/cm or less.

14. The carrier-attached metal foil according to claim 1 or 2,
wherein the carrier-attached metal foil has a redistribution layer on the metal layer, and
wherein when the carrier-attached metal foil is viewed in plan view, at least a portion of the redistribution layer reaches an end of the carrier.

15. The carrier-attached metal foil according to claim 14, wherein at least a portion of the end of the redistribution layer is located on the uneven region.

16. The carrier-attached metal foil according to claim 5, wherein a line width of the pattern of the uneven region R provided on the first surface is 0.1 mm or more and 50 mm or less.

17. The carrier-attached metal foil according to claim 1 or 2, further comprising:
a second release layer provided on the second surface of the carrier; and
a second metal layer having a thickness of 0.01 µm or more and 4.0 µm or less provided on the second release layer,
wherein the second metal layer extends from the second surface to the side face of the carrier so that at least a portion of the side face is covered by the second metal layer,
wherein the carrier further has the uneven region on the second surface, and
wherein the uneven region encompasses a region of the side face covered by the second metal layer.
